Europäisches Patentamt

European Patent Office

Office européen des brevets

(11) Veröffentlichungsnummer: **0 419 693 A1**

## (12) EUROPÄISCHE PATENTANMELDUNG

(21) Anmeldenummer: 89117694.3

(51) Int. Cl.5: **H01L 21/324**

(22) Anmeldetag: **25.09.89**

(43) Veröffentlichungstag der Anmeldung:
**03.04.91 Patentblatt 91/14**

(84) Benannte Vertragsstaaten:
**AT BE CH DE ES FR GB GR IT LI LU NL SE**

(71) Anmelder: **Siemens Aktiengesellschaft**
**Wittelsbacherplatz 2**
**W-8000 München 2(DE)**

(72) Erfinder: **Münzer, Adolf, Dipl.-Phys.**
**Orleansstrasse 67**
**W-8000 München 80(DE)**

(54) Verfahren zur Passivierung von Kristalldefekten in poly-kristallinem Silizium-Material.

(57) Ein Verfahren zur Passivierung von Kristalldefekten in polykristallinem oder amorphen Silizium-Material mit Hilfe einer Temperaturbehandlung in wasserstoff-haltiger Atmospähre soll in einfacher Weise günstige Diodeneigenschaften und/oder günstige Passivierungseigenschaften bei amorphem bzw. polykristallinem Silizium-Material ermöglichen. An der Oberfläche des Silizium-Materials werden Wasserstoff-Sauerstoff-Verbindungen reduziert, wodurch atomarer Wasserstoff entsteht, der in das Silizium-Material eindiffundiert.

# VERFAHREN ZUR PASSIVIERUNG VON KRISTALLDEFEKTEN IN POLYKRISTALLINEM SILIZIUM-MATERIAL

Die Erfindung betrifft ein Verfahren zur Passivierung von Kristalldefekten in polykristallinem Silizium-Material nach dem Oberbegriff des Patentanspruchs 1.

Polykristalline Siliziumscheiben bzw. Siliziumschichten bzw. Silizium-Material von beliebiger Form weisen normalerweise Kristalldefekte wie z. B. Punktdefekte oder Liniendefekte, Versetzungen oder Korngrenzen auf. Diese Kristalldefekte schlagen sich in einer verminderten Qualität der aus solchem Silizium-Material hergestellten elektronischen Bauelemente nieder. Solarzellen oder Fotodioden aus derartigen Silizium-Materialien weisen aufgrund erhöhter Rekombinationsströme verminderte Fotostrom-Empfindlichkeiten und Leerlauf-Spannungen auf. Grundsätzlich ergeben sich bei Verwendung solcher Silizium-Materialien ungünstige Dioden-Eigenschaften.

Die vorliegende Erfindung bezieht sich auch auf die Passivierung von amorphem Silizium-Material. Amorphes Silizium-Material wird ebenfalls für Solarzellen, Fotodioden sowie für elektrografische Aufzeichnungsmaterialien verwendet.

Zur Verminderung der Auswirkungen von Kristalldefekten werden beim Stand der Technik folgende Verfahren angewandt, die meist unter der Bezeichnung "Korngrenzen-Passivierung" laufen:
a) Implantation von ionisierten Wasserstoffatomen:
J. E. Johnson; J. I. Hano Ka; J. A. Gregory:
18. IEEE Photovoltaic Specialists Conference, Las Vegas 1985, S. 1112-1115.
b) Behandlung mit einem Wasserstoffplasma:
W. Schmidt; K.-D. Rasch; K. Roy:
16. IEEE Photovoltaic Specialists Conference, San Diego, 1982, S. 537-542; US-PS 4 835 006.
c) Temperaturbehandlung in einer Wasserstofatmosphäre:
A. Agarwal; D. Bana; C. M. Singal:
Int. I. Electr. 1985, Vol. 58, No. 5, S. 769-774.

Der vorliegenden Erfindung liegt die Aufgabe zugrunde, ein Verfahren der eingangs genannten Art anzugeben, das in einfacher Weise günstige Diodeneigenschaften und/oder günstige Passivierungseigenschaften bei amorphem bzw. polykristallinem Silizium-Material ermöglicht.

Diese Aufgabe wird erfindungsgemäß durch ein Verfahren nach dem Anspruch 1 gelöst.

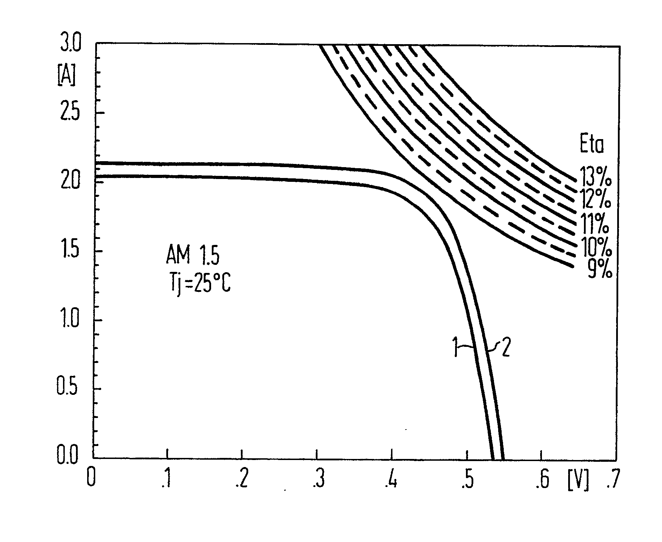

Vorteile und Ausgestaltungen der Erfindung sind in den Ansprüchen, der Beschreibung und der Zeichnung angegen.

Die Erfindung ermöglicht in einfacher Weise eine Verbesserung von Solarzellen-Parametern. Die Erfindung ermöglicht in einfacher Weise eine verbesserte Herstellung von elektronischen Bauelementen aus polykristallinem bzw. amorphen Silizium-Material.

Die Erfindung wird im folgenden anhand der Zeichnung näher erläutert. Die Figur zeigt I-U-Kennlinien von polykristallinen Solarzellen ohne Antireflexschicht vor und nach einer Temperaturbehandlung zur Passivierung von Kristalldefekten.

Die Passivierung von Korngrenzen und Innerkorndefekten in Silizium-Material kann durch Absättigung dieser Kristall-Störungen mit Wasserstoff-Atomen erfolgen. Dazu sind die zwei Prozeßschritte der Erzeugung atomaren Wasserstoffs und dessen Transport an die Kristallstörung zu bewerkstelligen. Für einen möglichst zerstörungsfreien Transport der erzeugten Wasserstoffatome an die Kristallstörung ist ein Diffusionsprozeß am geeignetsten. Die Erzeugung von Wasserstoffatomen erfolgt durch Reduktion von Wasserstoff-Sauerstoff-Verbindungen, z. B. Wasser, an der Silizium-Oberfläche. Dafür sind wasserstoff-haltige Verbindungen geeignet, deren Dissoziationsenergien bei einer bestimmten Temperatur kleiner sind als die Bindungsenergie von Silizium-Dioxid ($SiO_2$). Infolge einer Reduktion an der Oberfläche des Silizium-Materials entsteht dabei atomarer Wasserstoff, der bei einer entsprechenden Temperatur in das Silizium-Material zu den Kristallstörungen hineindiffundiert.

Als Beispiel dafür wurden polykristalline Silizium-Scheiben einer Temperaturbehandlung in einer wasser-haltigen Atmosphäre ausgesetzt. Der Temperaturbereich liegt dabei vorzugsweise zwischen ca. 250° C und 500° C. An Solarzellen aus derart behandeltem Silizium-Material konnten Verbesserungen im Kurzschlußstrom, in der Leerlaufspannung und in dem Füllfaktor ähnlich wie bei Anwendung geläufiger Passivierungsverfahren festgestellt werden.

Die Figur zeigt Strom-Spannungs-Kennlinien von polykristallinen Solarzellen vor und nach einer derartigen Behandlung in wasserhaltiger Atmosphäre. Die Kurve 1 zeigt dabei die Strom-Spannungskennlinie von polykristallinen Solarzellen ohne Antireflexschicht vor der Temperaturbehandlung. Die Kurve 2 zeigt die Strom-Spannungs-Kennlinie derselben polykristallinen Solarzelle ohne Antireflexschicht nach einer Temperaturbehandlung von 330° C in wasserhaltiger Atmosphäre zur Passivierung von Kristalldefekten. Ein Vergleich zwischen den Kurven 1 und 2 in der Figur läßt die Verbesserung der Solarzellenparameter "Kurzschlußstrom" und "Leerlaufspannung" deutlich erkennen.

Ein Verfahren nach der Erfindung kann bei normaler Atmosphäre durchgeführt werden. Ein Verfahren nach der Erfindung kann auch bei erhöhtem Druck durchgeführt werden, um eine höhere

Passivierungswirkung zu erreichen.

**Ansprüche**

1. Verfahren zur Passivierung von Kristalldefekten in polykristallinem oder amorphem Silizium-Material mit Hilfe einer Temperaturbehandlung in wasserstoff-haltiger Atmosphäre,
**dadurch gekennzeichnet,** daß an der Oberfläche des Silizium-Materials Wasserstoff-Sauerstoff-Verbindungen reduziert werden, wodurch atomarer Wasserstoff entsteht, der in das Silizium-Material eindiffundiert.
2. Verfahren nach Anspruch 1,
**gekennzeichnet durch** eine Temperaturbehandlung im Temperaturbereich zwischen 250° C und 500° C.
3. Verfahren nach Anspruch 1 oder 2,
**gekennzeichnet durch** die Verwendung von Wasser als Wasserstoff-Sauerstoff-Verbindung.
4. Verfahren nach einem der Ansprüche 1 bis 3,
**gekennzeichnet durch** Durchführung dieses Verfahrens bei höherem Druck als Normaldruck.

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| D,A | INTERNATIONAL JOURNAL OF ELECTRONICS, Band 58, Nr. 5, 1985, Seiten 769-774, Taylor and Francis Ltd, London, GB; A. AGARWAL et al.: "Passivation of defects in polycrystalline silicon solar cells by molecular hydrogen annealing" * Seite 770 * | 1,2 | H 01 L  21/324 |
| A | EP-A-0 264 762  (SIEMENS AG) * Zusammenfassung; Seite 7, Zeilen 39-51 * | 1 | |
| A | IBM TECHNICAL DISCLOSURE BULLETIN, Band 25, Nr. 3B, August 1982, Seiten 1683-1684, New York, US; J.M. AITKEN et al.: "Wet forming gas anneal to remove radiation damage from polysilicon gate MOSFETS" * Seite 1683 * | 1,3 | |
| A | EXTENDED ABSTRACTS, Band 86-1, Nr. 1, Mai 1986, Seite 460, Zusammenfassung Nr. 315, Princeton, New Jersey, US; L. AMMOR et al.: "Improvement of polycrystalline silicon wafers and solar cells by annealing in hydrogen gas flow" * Seite 460 * | 1,2 | RECHERCHIERTE SACHGEBIETE (Int. Cl.5) H 01 L |
| A | US-A-4 113 514  (RCA CORP.) * Zusammenfassung; Seite 2, Zeilen 54-64 * | 1,2 | |

Der vorliegende Recherchenbericht wurde für alle Patentansprüche erstellt

| Recherchenort | Abschlußdatum der Recherche | Prüfer |
|---|---|---|
| DEN HAAG | 09-05-1990 | GELEBART J.F.M. |

EPO FORM 1503 03.82 (P0403)